# EUROPEAN PATENT APPLICATION

(11) **EP 2 202 779 A2**
(43) Date of publication of application: **30.06.2010**
(21) Application number: 09180695.0
(22) Date of filing: 23.12.2009
(51) Int. Cl.: H01J 61/02, H01J 61/86, G03F 7/20

(54) **Light source**

(30) Priority: 27.12.2008 JP 2008335362
(71) Applicant: Ushio Denki Kabushiki Kaisha, Chiyoda-ku Tokyo 100-0004 (JP)
(72) Inventor: Sumitomo, Taku, Hyogo-ken (JP)
(74) Representative: Henkel, Feiler & Hänzel

(57) **Abstract**

A light source is provided. The light source includes: a discharge lamp (1) in which a pair of electrodes facing each other is disposed and a discharge medium is enclosed; and an energy beam irradiation unit (2) that emits an energy beam (8) toward a gap between the pair of electrodes. The energy beam irradiation unit (3) emits the energy beam (8) toward a bright spot that is formed near a tip end of the electrode when the discharge lamp is turned on by applying a voltage to the electrodes.

## Description

### BACKGROUND OF THE INVENTION

### Technical Field

The present disclosure relates to a light source for an exposure apparatus which is used in processes of manufacturing a semiconductor, a liquid crystal glass substrate, a color filter, and the like. More particularly, the present disclosure relates to a light source that includes a unit for supplying an energy beam to a light source which emits light in the ultraviolet wavelength region.

### Related Art

Recently, in the manufacturing processes of semiconductors, liquid crystal glass substrates, color filters, and the like, using an ultraviolet light source a decrease in process time and one-shot exposure to a large area object have been requested. Thus, a high-pressure discharge lamp as the ultraviolet light source has been required to emit higher intensity light. However, if the input electric power to the high-pressure discharge lamp is set simply higher, increasing load of the electrodes, which are disposed in a discharge chamber, makes substances of the electrodes evaporate, which causes the discharge chamber surface to become dark and shortens the lifetime of the lamp.

In order to solve the above problems, various proposals have been made. For example, U.S. Patent Application Pub. US2007/0228300 discloses a light source including a discharge chamber, in which a rare gas or mercury is enclosed, and a laser source which emits a continuous wave or pulse laser beam toward the center between a pair of ignition electrodes disposed within the inner space of the discharge chamber. In the light source disclosed in US2007/0228300, plasma is heated to a higher temperature by the laser beam, and high-intensity ultraviolet light can be emitted from the high temperature laser produced plasma.

In the above-mentioned light source, a Laser Produced Plasma (LPP) by the laser beam irradiated into the chamber is generated independently of the Discharge Produced Plasma (DPP) generated between the pair of electrodes, which are disposed in a chamber so as to face each other. However, since the laser produced plasma (LPP) oscillates along the optical axis of the laser beam, the laser produced plasma (LPP) fluctuates in position rarely along the optical axis of the laser beam. In particular, the positional fluctuation of the laser produced plasma (LPP) is remarkable when mercury and xenon gas are enclosed in the discharge chamber. For this reason, there is a problem in that flickering occurs in the light emitted from the light source. In addition, US2007/0228300 does not clearly disclose which position in the discharge chamber the laser beam is incident to.

### SUMMARY OF THE INVENTION

Exemplary embodiments of the present invention address the above disadvantages and other disadvantages not described above. However, the present invention is not required to overcome the disadvantages described above, and thus, an exemplary embodiment of the present invention may not overcome any of the disadvantages described above.

Accordingly, it is an illustrative aspect of the present invention to provide a light source in which flickering from the light source can be prevented even when the laser produced plasma (LPP) continuously fluctuates in the direction of the optical axis.

According to one or more illustrative aspects of the present invention, there is provided a light source. The light source includes: a discharge lamp in which a pair of electrodes facing each other is disposed and a discharge medium is enclosed; and an energy beam irradiation unit that emits an energy beam toward a gap between the pair of electrodes. The energy beam irradiation unit emits the energy beam toward a bright spot that is formed near a tip end of the electrode when the discharge lamp is turned on by applying a voltage to the electrodes.

Other aspects of the invention will be apparent from the following description, the drawings and the claims.

### BRIEF DESCRIPTION OF THE DRAWINGS

Fig. 1 is a perspective view illustrating a schematic configuration of a light source according to a first exemplary embodiment of the present invention;
Fig. 2 is a front sectional view illustrating a configuration of a discharge lamp when turning on the light source shown in Fig. 1 in DC operation;
Fig. 3 is a front sectional view illustrating a discharge lamp 1 as a comparative example of the discharge lamp 1 shown in Fig. 2;
Fig. 4 is a front sectional view illustrating a configuration of the discharge lamp when turning on the light source shown in Fig. 1 in AC operation;
Fig. 5 is a perspective view illustrating a schematic configuration of the light source according to a second exemplary embodiment of the present invention;
Fig. 6 is a front sectional view illustrating a configuration of a discharge lamp when turning on the light source shown in Fig. 5 in DC operation; and
Fig. 7 is a front sectional view illustrating a configuration of the discharge lamp when turning on the light source shown in Fig. 5 in AC operation.

### DETAILED DESCRIPTION OF EXEMPLARY EMBODIMENTS

Exemplary embodiments of the present invention will be now described with reference to the drawings.

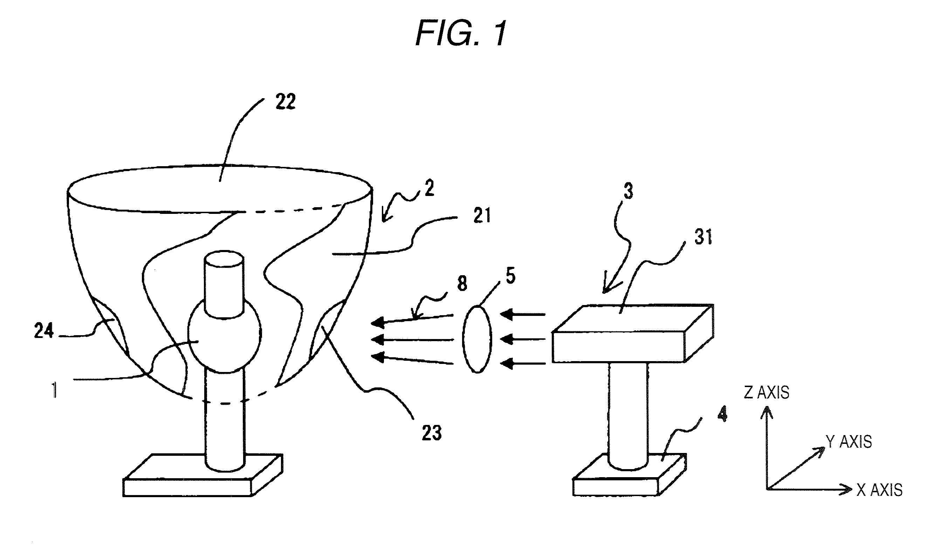

A first exemplary embodiment of the present invention will be described with reference to Figs. 1 to 4.

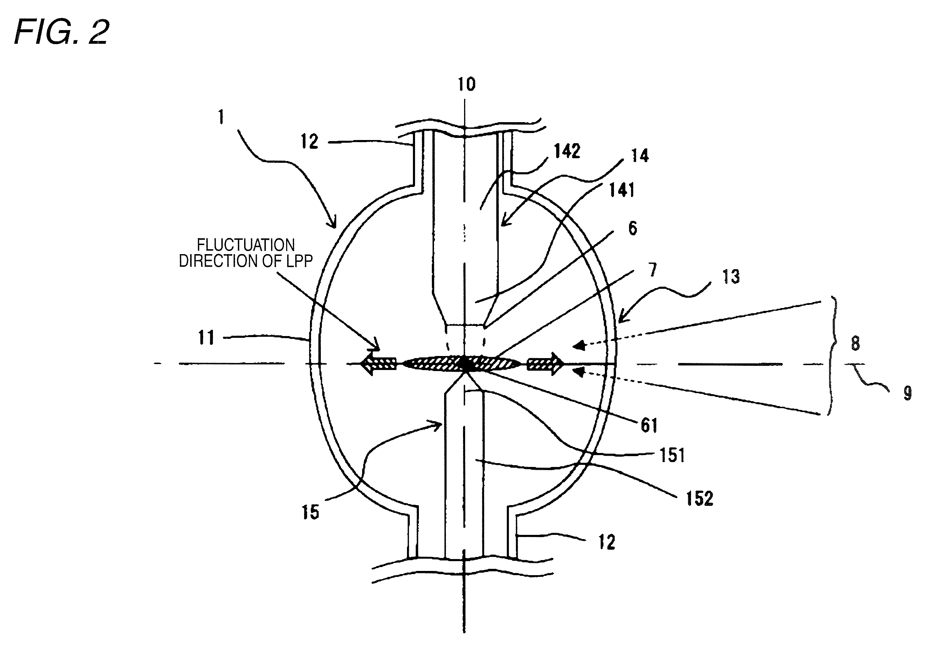

Fig. 1 is a perspective view illustrating a schematic configuration of the light source according to the first exemplary embodiment of the present invention. Fig. 2 is a front sectional view illustrating a configuration of a discharge lamp when turning on the light source shown in Fig. 1 in DC operation.
As shown in Fig. 1, the light source includes: a discharge lamp 1; a collecting mirror 2 which is disposed to surround the discharge lamp 1; an energy beam irradiation unit 3 which irradiates an energy beam such as a laser beam; and an energy beam position control unit 4 which controls an irradiation position of the energy beam by moving the energy beam irradiation unit 3.

The discharge lamp 1 is, for example, a short arc type high-pressure mercury lamp in which mercury is enclosed as a luminescent medium as shown in Fig. 2. As shown in the drawing, in the DC operation, the discharge lamp 1 is constituted by a arc tube 13 including a light-emitting portion 11 formed in a substantially spherical shape and a sealing portion 12 extending outwardly from the both ends of the light-emitting portion 11. The light-emitting portion 11 has an anode 14 and a cathode 15 disposed to face each other, and a DC voltage is applied between the anode 14 and the cathode 15. The arc tube 13 is made of an ultraviolet-transparent material such as quartz, glass, or the like. In the light-emitting portion 11, a discharge medium such as mercury and/or xenon gas is enclosed. The anode 14 includes a tip end portion 141 formed in a truncated conic shape and a body portion 142 formed in a cylindrical shape and extending from the tip end portion 141. The base part of the body portion 142 is supported by the sealing portion 12. The cathode 15 includes a pointed head portion 151 formed in the tip end portion and a body portion 152 formed in a cylindrical shape and extending from the pointed head portion 151. The base part of the body portion 152 is supported by the sealing portion 12. The anode 14 and the cathode 15 are made of a material with a high melting point, such as tungsten.

In Fig. 1, the collecting mirror 2 has a bowl shape as a whole, and is, for example, a spheroid reflection mirror or a parabolic reflection mirror. The collecting mirror 2 is disposed such that a first focal point thereof is substantially located near the tip end of the pointed head portion 151 of the cathode 15 of the discharge lamp 1 and also the collecting mirror 2 is disposed to surround the discharge lamp 1. The collecting mirror 2 includes a reflective surface 21 made of a multilayer film. The multilayer film may be formed by alternately forming HfO₂ (hafnium oxide) and SiO₂ (silicon oxide) or may be formed by alternately forming Ta₂O₅ (tantalum oxide) and SiO₂ (silicon oxide). The collecting mirror 2 reflects the ultraviolet light, which is output from the discharge lamp 1, by the reflective surface 21, so that the ultraviolet light exits from the light-exit opening 22. Further, on the side surfaces of the collecting mirror 2, there are provided openings 23, 24. The opening 23 allows a laser beam 8, which is emitted from the energy beam irradiation unit 3, to enter the collecting mirror 2, and the opening 24 allows the laser beam which is not absorbed by the laser produced plasma in the discharge lamp 1 to pass through out the collecting mirror 2.

The energy beam irradiation unit 3 includes, for example, a laser oscillator 31 for emitting a laser beam toward the gap between the pair of electrodes 14 and 15 of the discharge lamp 1. The laser beam 8, which is emitted from the laser oscillator 31, is adjusted by an optical system 5, which is disposed in front of the laser oscillator 31. Thus, the laser beam 8 can have an appropriate beam diameter size. Further, the laser beam 8 is irradiated to the gap between the pair of electrodes 14 and 15 of the discharge lamp 1 through the opening 23 provided on the side surface of the collecting mirror 2. A continuous wave (CW) laser, which is emitted from the energy beam irradiation unit 3, includes, for example, a semiconductor laser and a fiber laser etc. A pulse laser can be, for example, a YAG laser and a CO₂ laser etc. The laser beam 8 is, for example, a fiber laser having an oscillation wavelength of about 1065 nm and a continuous oscillation output of about 500 W.

As shown in Fig. 2, when the discharge lamp 1 is turned on by applying a DC voltage between the electrodes 14 and 15, discharge is generated between the pair of electrodes 14 and 15. Thereby, discharge produced plasma (DPP) 6 is formed, and a bright spot 61 is formed near the tip end of the pointed head portion 151 of the cathode 15. The energy beam position control unit 4 is operable to move the laser oscillator 31 in 3-dimensions (X, Y, and Z axes) and positions the laser oscillator 31 so that the optical axis 9 of the laser beam 8 is almost orthogonal to a tube axis 10 of the discharge lamp 1 and the laser beam 8 is focused on the bright spot 61 which is formed near the tip end of the pointed head portion 151 of the cathode 15. Furthermore, the bright spot 61 indicates a region that is close to the cathode 15 from the straight line which passes through the center between the anode 14 and the cathode 15 and is orthogonal to the tube axis 10 of the lamp 1, and more particularly, indicates a region that is formed near the tip end of the cathode 15.

In the light source according to the exemplary embodiment of the invention, as shown in Fig. 2, the laser beam 8 is irradiated toward the bright spot 61 of the discharge lamp 1 such that the optical axis 9 of the laser beam 8 is almost orthogonal to the tube axis 10 of the discharge lamp 1. With such a configuration, the following effects can be expected.
Firstly, between the pair of electrodes 14 and 15 in the discharge lamp 1, the discharge produced plasma (DPP) 6 is formed along the tube axis 10 of the discharge lamp 1. By allowing the laser beam 8 to enter the light-emitting portion 11 of the discharge lamp 1, the laser produced plasma (LPP) 7 is formed in the direction of the optical axis of the laser beam 8. Since the tube axis 10 of the discharge lamp 1 and the optical axis 9 of the laser beam 8 are almost orthogonal to each other, the discharge produced plasma (DPP) 6 and the laser produced plasma (LPP) 7 are formed to be almost orthogonal to each other. The bright spot 61 of the discharge lamp 1 is located at a position where brightness is highest in the discharge produced plasma (DPP) 6. When the laser produced plasma (LPP) 7 is formed such that the laser beam 8 is irradiated on the bright spot 61, the bright spot 61 of the discharge produced plasma (DPP) 6 is overlapped with the laser produced plasma (LPP) 7, which enables to obtain ultra bright plasma. Consequently, in the light source using the light collected by the collecting mirror 2, a light incidence region is made to be concentrated, and thus it is possible to improve light intensity of the light incidence region.

In this case, even when the laser produced plasma (LPP) 7 continuously fluctuates in the direction of the optical axis of the laser beam 8, flickering of the light source can be reduced as much as possible. The reason is as follows. The mixed plasma, which is formed by overlapping the laser produced plasma (LPP) 7 with the discharge produced plasma (DPP) 6 at the bright spot 61 of the discharge lamp 1, has a very high brightness at the bright spot 61 of the discharge produced plasma (DPP) 6, and a ratio of the brightness of the laser produced plasma (LPP) 7 relative to the brightness of the mixed plasma is low in view of the entire mixed plasma. As a result, the flickering of the light source caused by the fluctuation of the laser produced plasma (LPP) 7 causes little problem.

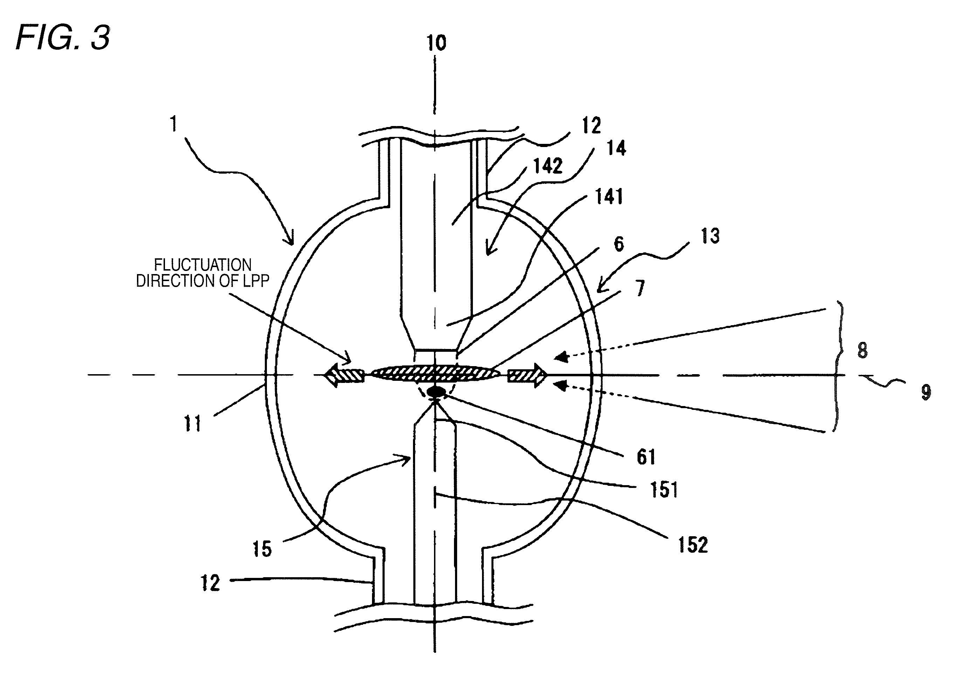

Fig. 3 is a front sectional view illustrating a discharge lamp 1 as a comparative example of the discharge lamp 1 shown in Fig. 2. As shown in the drawing, in the discharge lamp 1, the laser beam 8 is irradiated toward the center between the pair of electrodes 14 and 15, that is, the center of the discharge produced plasma (DPP) 6 formed between the pair of electrodes 14 and 15. In such a case, it is difficult to suppress flickering of the light emitted from the discharge lamp 1. Specifically, the laser produced plasma (LPP) 7 is formed by irradiating the laser beam 8 at a location where a brightness is low in the discharge produced plasma (DPP) 6. Accordingly, in view of the entire mixed plasma, a ratio of the brightness of the laser produced plasma (LPP) 7 relative to the brightness of the mixed plasma is higher than that of the discharge lamp 1 shown in Fig. 2. Therefore, it can be considered that the influence of the fluctuation of the laser produced plasma (LPP) 7 with respect to the mixed plasma of the discharge produced plasma (DPP) 6 and the laser produced plasma (LPP) 7 is increased and thus the flickering of the light source is increased.

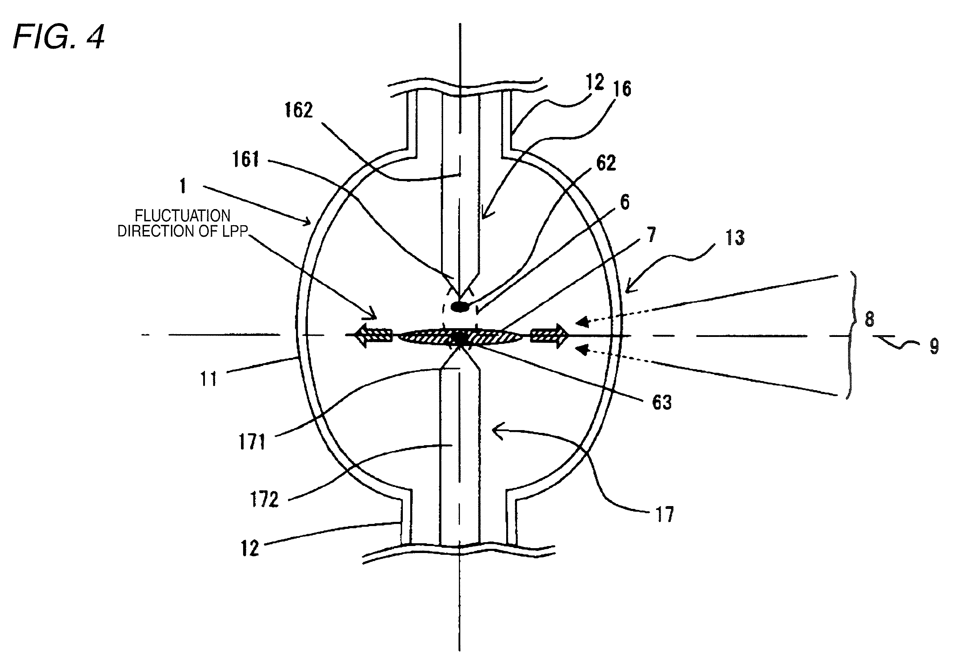

Fig. 4 is a front sectional view illustrating a configuration of the discharge lamp 1 when turning on the light source shown in Fig. 1 in AC operation.
As shown in the drawing, in the AC operation discharge lamp, the discharge lamp 1 is constituted by an arc tube 13 including a light-emitting portion 11 formed in a substantially spherical shape and a sealing portion 12 extending from the both ends of the light-emitting portion 11. The light-emitting portion 11 has an electrode 16 and an electrode 17 disposed to face each other, and an AC voltage is applied between the electrode 16 and the electrode 17. The arc tube 13 is made of an ultraviolet-transparent material such as quartz, glass, or the like. In the light-emitting portion 11, a discharge medium such as mercury or xenon gas may be enclosed. The electrodes 16 and 17 include: pointed head portions 161 and 171 formed on the tip end portions thereof; and body portions 162 and 172 formed in cylindrical shapes and extending from the tip end portions. The base parts of the body portions 162 and 172 are supported by the sealing portions 12. The electrodes 16 and 17 are made of a material with a high melting point, such as tungsten.

As shown in the drawing, in the case of the AC operation, bright spots 62 and 63 of the discharge produced plasma (DPP) 6 formed in the light-emitting portion 11 are formed near the tip ends of the electrodes 16 and 17 whenever the polarity of the applied AC voltage is changed. The laser beam 8, which is emitted from the energy beam irradiation unit 3, is irradiated toward the bright spot 62 (63) that is formed near the tip end of the electrode 16 (17). In such a manner, on the basis of the same reason as the case of the DC lighting method, it is possible to prevent the light source from flickering even when the laser produced plasma (LPP) 7 fluctuates in position. The bright spots indicate regions that are close to the electrodes 16, 17 from the straight line which passes through the center between the electrodes 16, 17 and is almost orthogonal to the tube axis of the lamp, and more particularly, indicate regions that are formed near the tip ends of the electrodes 16, 17.

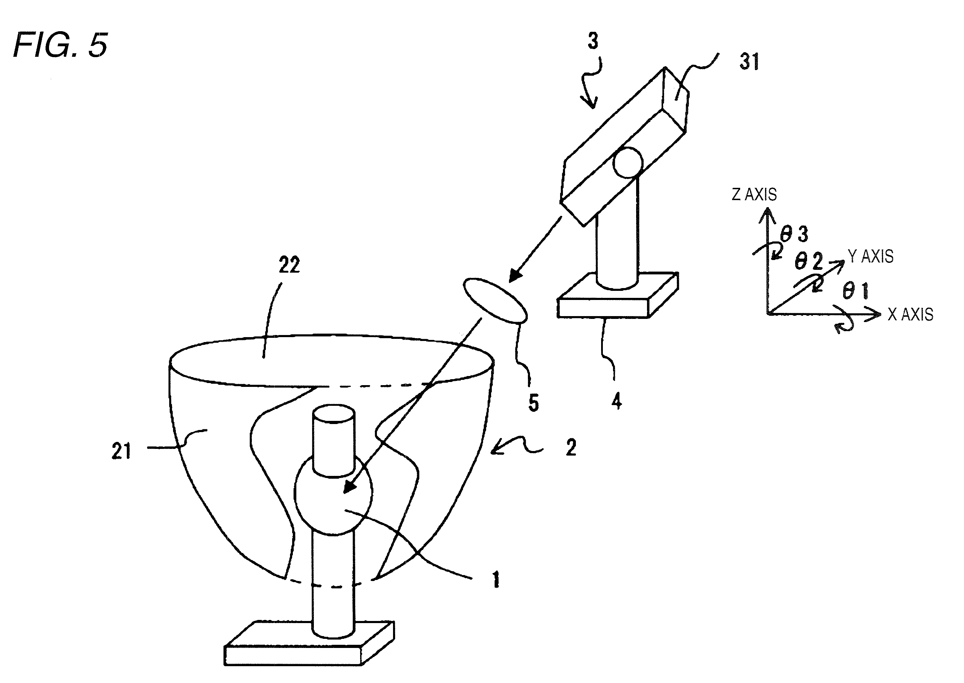

A second exemplary embodiment of the present invention will be described with reference to Figs. 5 to 7.

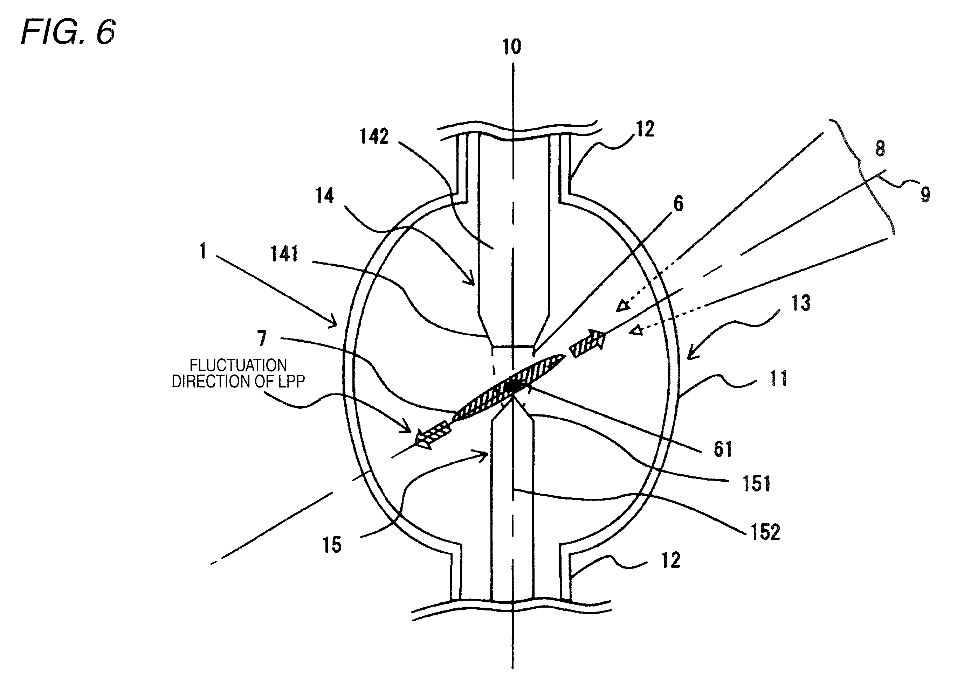

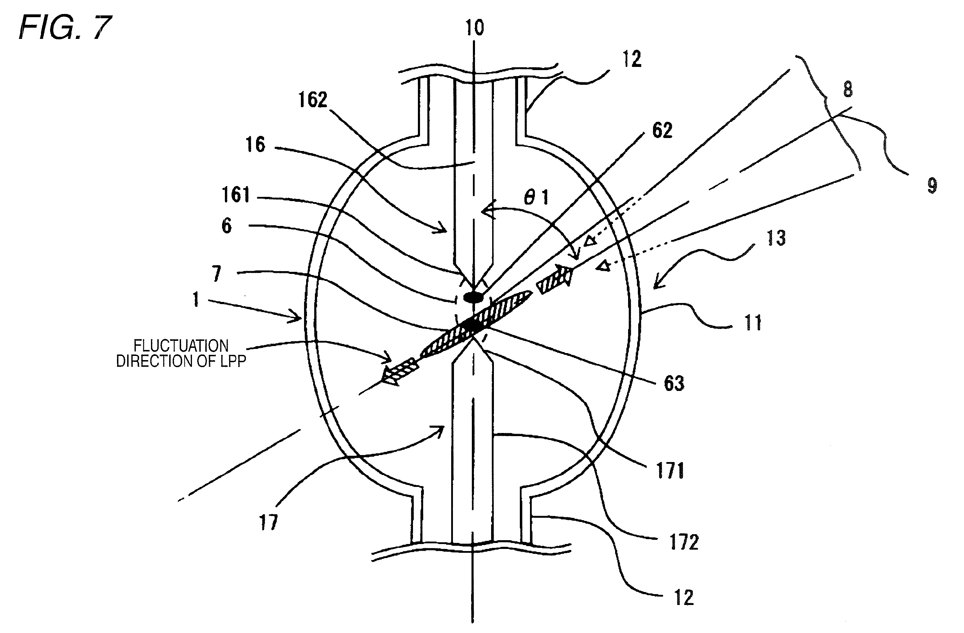

Fig. 5 is a perspective view illustrating a schematic configuration of the light source according to a second exemplary embodiment of the present invention. Fig. 6 is a front sectional view illustrating a configuration of a discharge lamp when turning on the light source shown in Fig. 5 in DC operation. Fig. 7 is a front sectional view illustrating a configuration of the discharge lamp when turning on the light source shown in Fig. 5 in AC operation.
In Fig. 5, components of the light source according to the exemplary embodiment correspond to the components denoted by the reference numerals and signs shown in Fig. 1, and thus detailed description thereof will be omitted hereinafter. In Fig. 5, θ1 represents a rotational angle about the X axis, θ2 represents a rotational angle about the Y axis, and θ3 represents a rotational angle about the Z axis.

As shown in Fig. 6, when the discharge lamp 1 is turned on by applying a DC voltage between the anode 14 and cathode 15, discharge is generated between the anode 14 and the cathode 15. Thereby, discharge produced plasma (DPP) 6 is formed, and a bright spot 61 is formed near the tip end of the pointed head portion 151 of the cathode 15. As shown in Fig. 5, the energy beam position control unit 4 is configured to control the position of the laser beam 8, which is emitted from the laser oscillator 31, in 3-dimensions (X, Y, and Z axes) and in rotational directions (θ1 around the X axis, θ2 around Y axis, and θ3 around the Z axis). In such a manner, the energy beam position control unit 4 positions the laser oscillator 31 such that the optical axis 9 of the laser beam 8 obliquely crosses the tube axis 10 of the discharge lamp 1 and the laser beam 8 is focused on the bright spot 61 formed near the tip end of the pointed head portion 151 of the cathode 15.

In the light source according to the exemplary embodiment of the invention, as shown in Fig. 6, the laser beam 8 is irradiated toward the bright spot 61 of the discharge lamp 1 such that the optical axis 9 of the laser beam 8 obliquely crosses the tube axis 10 of the discharge lamp 1. With such a configuration, the following effects can be expected.
Between the pair of electrodes 14 and 15 in the discharge lamp 1, the discharge produced plasma (DPP) is formed along the tube axis 10 of the discharge lamp 1. Further, by allowing the laser beam 8 to enter the light-emitting portion 11 of the discharge lamp 1, the laser produced plasma (LPP) is formed in the direction of the optical axis of the laser beam 8. Since the tube axis 10 of the discharge lamp 1 obliquely crosses the optical axis 9 of the laser beam 8, the laser produced plasma (LPP) 7 is formed obliquely to the discharge produced plasma (DPP) 6. With such a configuration, the bright spot 61 of the discharge lamp 1 is located at a position where brightness is highest in the discharge produced plasma (DPP) 6, and the laser produced plasma (LPP) 7 is formed such that the laser beam 8 is irradiated on the bright spot 61. By overlapping the bright spot 61 of the discharge produced plasma (DPP) 6 with the laser produced plasma (LPP) 7, it is possible to obtain ultra bright plasma.

In this case, even when the laser produced plasma (LPP) 7 continuously fluctuates in the direction of the optical axis of the laser beam 8, flickering of the light source can be reduced as much as possible. The reason is as follows. The mixed plasma, which is formed by overlapping the bright spot 61 of the discharge produced plasma (DPP) 6 with the laser produced plasma (LPP) 7, has a very high brightness at the bright spot 61 of the discharge produced plasma (DPP) 6, and a ratio of the brightness of the laser produced plasma (LPP) 7 with respect to the brightness of the mixed plasma is low in view of the entire mixed plasma. As a result, it is possible to reduce the flickering of the light source caused by the fluctuation of the laser produced plasma (LPP) 7.

As shown in Fig. 7, in the case of the AC operation, bright spots 62 and 63 of the discharge produced plasma (DPP) 6 formed in the light-emitting portion 11 are formed near the tip ends of the electrodes 16 and 17 whenever the polarity of the applied AC voltage is changed. The laser beam 8, which is emitted from the energy beam irradiation unit 3, is obliquely irradiated toward the bright spot 62 (63) formed near the tip end of the electrode 16 (17). In such a manner, on the basis of the same reason as the case of the DC lighting method, it is possible to prevent the light source from flickering even when the laser produced plasma (LPP) 7 fluctuate in position.

## Claims

1. A light source comprising:
a discharge lamp in which a pair of electrodes facing each other is disposed and a discharge medium is enclosed;
an energy beam irradiation unit that emits an energy beam toward a gap between the pair of electrodes,
wherein the energy beam irradiation unit emits the energy beam toward a bright spot that is formed near a tip end of the electrode when the discharge lamp is turned on by applying a voltage to the electrodes.

2. The light source according to claim **1,** wherein the energy beam irradiation unit emits the energy beam in a direction intersecting a tube axis of the discharge lamp.

3. The light source according to claim **1,** further comprising:
a position control unit that controls a position of the energy beam irradiation unit such that the energy beam is emitted toward the bright spot.

4. The light source according to claim **2,** wherein the energy beam irradiation unit emits the energy beam in a direction substantially orthogonal to the tube axis of the discharge lamp.
